# EUROPÄISCHE PATENTSCHRIFT

(11) **EP 0 845 632 B1**
(45) Veröffentlichungstag und Bekanntmachung des Hinweises auf die Patenterteilung: **14.05.2003**
(21) Anmeldenummer: 97117554.2
(22) Anmeldetag: 10.10.1997
(51) Int. Cl.: F21S 8/10, F21V 23/06

(54) **Heckleuchte für Kraftfahrzeuge**
Rear lamp for motor vehicles.
Feu arrière pour automobiles.

(30) Priorität: 30.11.1996 DE 19649722
(43) Veröffentlichungstag der Anmeldung: 03.06.1998
(73) Patentinhaber: Schefenacker Vision Systems Germany GmbH & Co. KG, 73730 Esslingen (DE)
(72) Erfinder: Bauder, Rudolf, 75394 Oberreichenbach (DE)
(74) Vertreter: Jackisch-Kohl, Anna-Katharina

(56) Entgegenhaltungen:
- EP-A- 0 624 495
- DE-A- 2 732 780
- DE-A- 4 243 175
- GB-A- 2 027 291
- US-A- 4 173 035
- US-A- 4 307 927

## Beschreibung

Die Erfindung betrifft eine Heckleuchte für Kraftfahrzeuge nach dem Oberbegriff des Anspruches 1.

Bei bekannten Heckleuchten sind in der Aufnahme der Leiterplatte die verschiedenen Glühlampen für das Bremslicht, das Schlußlicht oder den Blinker eingesetzt. Die elektrische Zuleitung erfolgt über Kabelschuhverbindungen, die eine aufwendige und teure Montage erfordern.

Bei der gattungsgemäßen Heckleuchte (EP-A-0 624 495) ist die Leiterplatte, welche die Glühlampen trägt, mit einem Anschluß für die elektrische Zuleitung zu den Glühlampen versehen. Außerdem ist über Steckstifte an die Leiterplatte eine Platine angeschlossen, die Bauelemente einer Demultiplexschaltung und einer Leistungsschaltung trägt. Die Kontaktstifte ragen durch Öffnungen in der Platine, an der diese Kontakte aufgelötet werden. Es besteht darum nicht die Möglichkeit, die Platine von der Leiterplatte abzunehmen. Zudem sind die Montage und Demontage der Heckleuchte aufwendig und kostspielig.

Es ist ferner bekannt (DE 27 32 780 A), auf einer Leiterplatte LEDs zu befestigen. Ein elektrische Anschluß ist über eine Klemmschraube, einen Steckstift, eine Schraube, ein Bajonett oder eine Bajonettdoppelfassung an der Leiterplatte befestigt.

Aus der US-A-4 307 927 ist ein Polarisationsschlüssel bekannt, der eine Steckerbuchse mit federnden Zungen aufweist, in die eine Leiterplatte gesteckt wird.

Es ist schließlich ein elektrische Verbinder bekannt (GB-A-2 027 291), der federelastische, gebogene Zungen aufweist.

Der Erfindung liegt die Aufgabe zugrunde, die gattungsgemäße Heckleuchte so auszubilden, daß sie bei einfacher Montage und Demontage einfach und kostengünstig gefertigt und montiert werden kann.

Diese Aufgabe wird bei der gattungsgemäßen Heckleuchte erfindungsgemäß mit den kennzeichnenden Merkmalen des Anspruches 1 gelöst.

Die erfindungsgemäße Heckleuchte kann einfach und schnell montiert werden. Die die LEDs aufweisende Platine wird so an die Leiterplatte angesetzt, daß der Kontakt der Leiterplatte klemmend zwischen den federelastischen Zungen der Platine festgeklemmt wird. Die Platine wird dadurch zuverlässig fest an der Leiterplatte gehalten. Aufwendige Lötarbeiten zur Befestigung der Platine an der Leiterplatte sind nicht notwendig. Bei Bedarf kann die Platine einfach von der Leiterplatte gelöst werden. Die Platine läßt sich einfach und kostengünstig herstellen. Die LED's sind ebenfalls kostengünstige Bauteile und können für das Blink-, das Brems-, das Schluß- und das Rückfahrlicht eingesetzt werden. Je nach Einsatzfall sind die LEDs unterschiedlich eingefärbt.

Weitere Merkmale der Erfindung ergeben sich aus den weiteren Ansprüchen, der Beschreibung und den Zeichnungen.

Die Erfindung wird nachstehend anhand eines in den Zeichnungen dargestellten Ausführungsbeispiels näher erläutert. Es zeigen
- Fig. 1: eine Draufsicht auf eine Platine mit LEDs sowie Steckverbindern einer erfindungsgemäßen Heckleuchte,
- Fig. 2: die Platine gemäß Fig. 1 in Ansicht nach Pfeil II in Fig. 1,
- Fig. 3: eine Leiterplatte der erfindungsgemäßen Heckleuchte in Ansicht gemäß Pfeil III in Fig. 4,
- Fig. 4: eine Draufsicht auf die Leiterplatte gemäß Fig. 3,
- Fig. 5: einen der Steckverbinder gemäß Fig. 1 in Stirnansicht und in vergrößerter Darstellung,
- Fig. 6: den Steckverbinder nach Fig. 5 in Seitenansicht gemäß Pfeil VI in Fig. 5,
- Fig. 7: eine Draufsicht auf den Steckverbinder entsprechend Pfeil VII in Fig. 5,
- Fig. 8: den Steckverbinder nach Fig. 5 in Abwicklung.

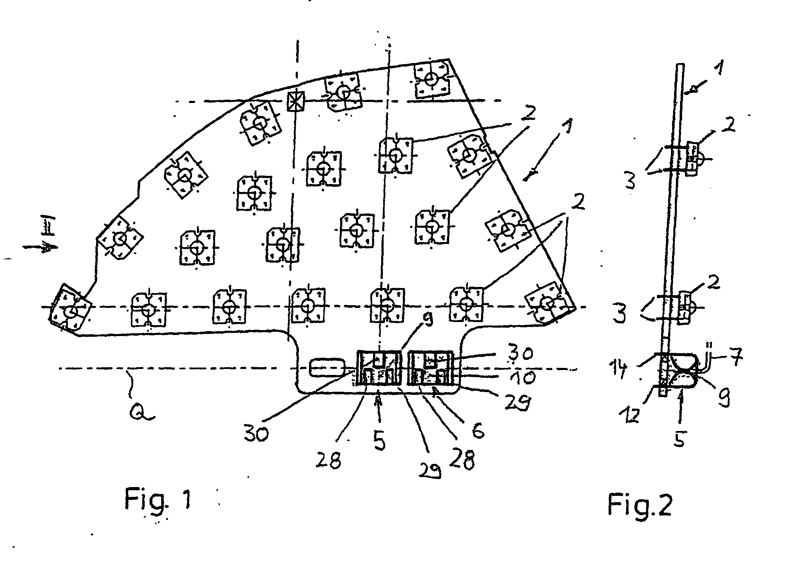

Die in den Fig. 1 bis 8 dargestellte Platine, Leiterplatte sowie Steckverbinder sind Teil einer Heckleuchte für ein Kraftfahrzeug.

Die gedruckte Platine 1 gemäß den Fig. 1 und 2 trägt mehrere LED's 2, die mit Füßen 3 auf der Platine 1 verlötet sind. Die Stromzuführung zu den LED's erfolgt über zwei Steckverbinder 5, 6, über welche die Platine 1 an eine Leiterplatte 4 angeschlossen wird.

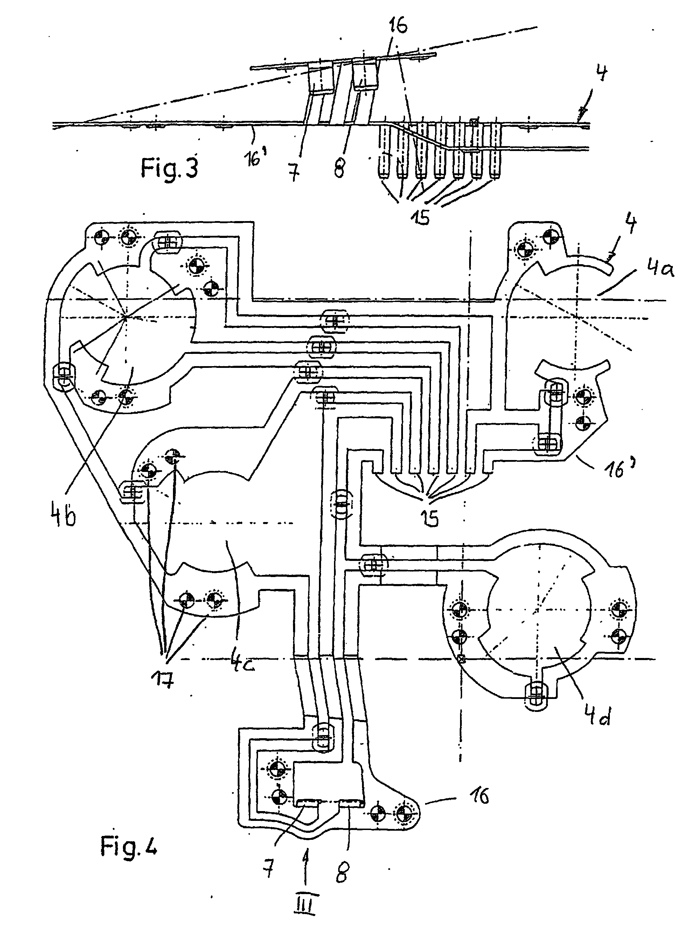

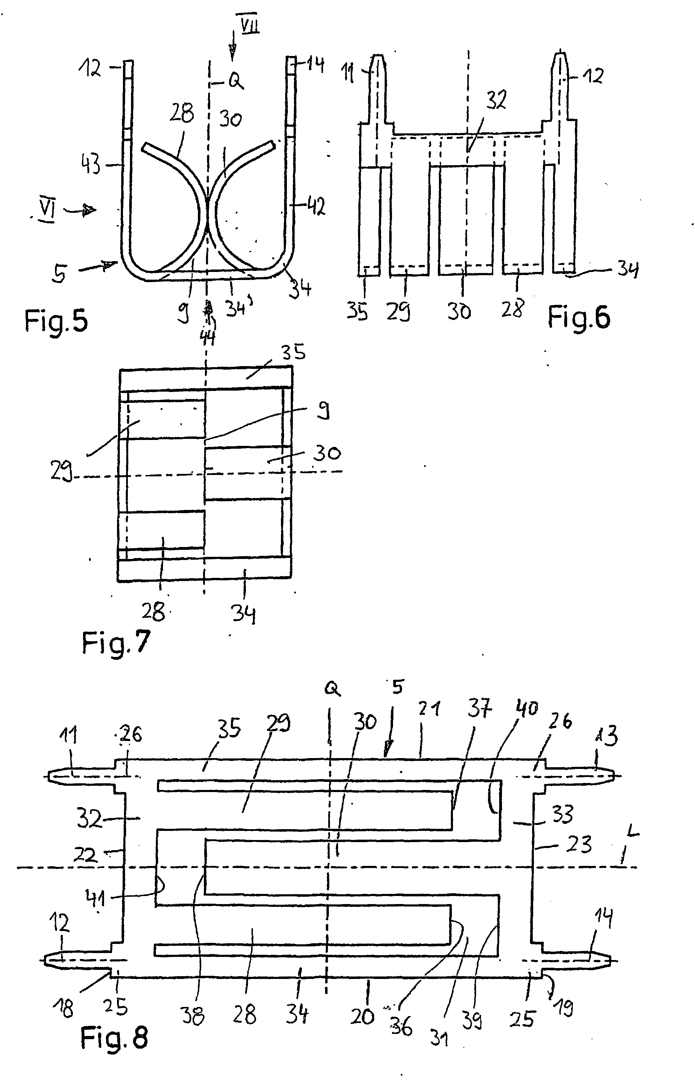

Die Leiterplatte 4 (Fig. 3 und 4) weist Kontakte 7 und 8 auf, die laschenartig ausgebildet sind und in Stecköffnungen 10 der Steckverbinder 5, 6 der Platine 1 gesteckt werden. Die Steckverbinder 5, 6 sind mit Steckstiften 11 bis 14 (Fig. 8), die durch entsprechende Stecköffnungen der Platine ragen, in der Platine 1 durch Löten befestigt.

Die Leiterplatte 4 besteht in bekannter Weise aus elektrisch leitendem Material, vorzugsweise aus verzinktem Blech. Sie weist (nicht näher dargestellte) Plus- und Minus- Zuleitungen für Glühlampen auf, für die Aufnahmen 4a bis 4d (Fig. 4) vorgesehen sind. Die Leiterplatte 4 ist an der Rückseite eines (nicht dargestellten) Reflektorgehäuses der Kraftfahrzeugheckleuchte, vorzugsweise durch Warmverformung von Kunststoffnieten, befestigt, die durch Öffnungen 17 der Leiterplatte gesteckt werden.

Die Leiterplatte 4 hat mehrere, in Reihe nebeneinander liegende Anschlußkontakte 15 für einen (nicht dargestellten) Mehrfachstecker. Über sie erfolgt die Stromzuführung von der Fahrzeugbatterie. Die Kontakte 7 und 8 sind an einem aus der Leiterplattenebene herausgebogenen Leiterplattenteil 16 (Fig. 3) vorgesehen, über den sie im wesentlichen senkrecht in Richtung auf einen Plattenteil 16' der Leiterplatte 4 ragen.

In den Fig. 5 bis 8 ist der Steckverbinder 5 im einzelnen dargestellt. Der andere Steckverbinder 6 ist gleich ausgebildet und wird darum nicht näher beschrieben.

Wie insbesondere Fig. 8 zeigt, wird der Steckverbinder 5 aus einem Plattenteil hergestellt, vorzugsweise gestanzt. Die Steckstifte 11 bis 14 sind gleich ausgebildet; sie ragen über die Schmalseiten 18 und 19 des annähernd rechteckigen Plattenteiles 5. Die Steckstifte 11 bis 14 liegen relativ nahe benachbart zu den Längsseiten 20 und 21 des Plattenteiles, der zu seiner Längsmittelebene L symmetrisch ausgebildet ist.

Zwischen den einander gegenüberliegenden Steckstiften 11, 12 und 13, 14 weisen die Schmalseiten 18, 19 jeweils eine u-förmige Vertiefung 22, 23 auf, die relativ große Breite hat, so daß an beiden Längsseiten 20 und 21 jeweils Vorsprünge 25 und 26 gebildet sind, über die die Steckstifte 11 bis 14 ragen. Sie verjüngen sich im Bereich ihrer freien Enden vorzugsweise trapezförmig, um ein leichtes Einführen in die zugehörigen Stecköffnungen der Platine 1 zu gewährleisten.

Zwischen den einander gegenüberliegenden Längsrändern 20 und 21 sind Zungen 28 bis 30 gebildet, die von einer mäanderförmig verlaufenden Ausnehmung 31 umgeben sind. Die Zungen 28 bis 30 sind im wesentlichen gleich lang und verlaufen parallel zueinander und zu den Längsseiten 20 und 21. Die Zungen 28 und 29 gehen in einen die Schmalseite 22 aufweisenden schmalen Rand 32 über, während die Zunge 30 an einen die andere Schmalseite 23 aufweisenden schmalen Rand 33 anschließt. Im Ausführungsbeispiel ist die mittlere Zunge 30 etwas breiter ausgebildet als die Zungen 28 und 29, die gleich ausgebildet sind. Die Zungen 28 und 29 liegen mit gleichem Abstand von den benachbarten, die Längsseiten 20 und 21 aufweisenden Längsrändern 34 und 35 sowie von der mittleren Zunge 30. Die freien ebenen Stirnseiten 36 bis 38 der Zungen 28 bis 30 haben von parallel zu ihnen verlaufenden, senkrecht zur Längsmittelebene L sich erstrekkenden Innenseiten 39 bis 41 der Ränder 32, 33 um ein Mehrfaches größeren Abstand als die Zungen voneinander.

Aus der in Fig. 8 dargestellten abgewickelten Ausgangslage wird das gestanzte Plattenteil so gebogen, daß es die in Stirnansicht gemäß Fig. 5 u-förmige Form aufweist. Die Zungen 28 bis 30 werden teilkreisförmig nach innen gebogen. Die Zungen 28, 29 sind entgegengesetzt zur Zunge 30 gebogen. In Stirnansicht gemäß Fig. 5 gesehen, berühren die Zungen 28, 29 und 30 einander in der Quermittelebene Q des Steckverbinders 5. Die Zungen 28 bis 30 werden so weit gebogen, daß ihre Stirnseiten 36 bis 38 nur geringen Abstand von den benachbarten Schenkeln 42, 43 des Steckverbinders 5 haben (Fig. 5). Die Schenkel 42, 43 werden durch einen Teil der Längsränder 34, 35 des Plattenteiles (Fig. 8) gebildet und sind etwa um ein Drittel länger als der sie verbindende Quersteg 34', der ebenfalls durch einen Teil der Längsränder 34, 35 des Plattenteiles gebildet wird.

Die Zungen 28 bis 30 sind jeweils vorzugsweise etwa halbkreisförmig nach innen in Richtung auf die freien Enden der Schenkel 42, 43 gebogen und erstrecken sich nahezu über die Länge der Schenkel 42, 43.

Bei montierter Heckleuchte ist die Platine 1 an der Leiterplatte 4 befestigt, indem die Kontakte 7, 8 in die im Bereich des Quersteges 34' der Steckverbinder 5, 6 vorgesehen Stecköffnungen 9 und 10 der beiden Steckverbinder 5 und 6 gesteckt werden. Da die Zungen 28 bis 30 bis zur Quermittelebene Q des jeweiligen Steckverbinders 5, 6 reichen (Fig. 1) und jeweils teilkreisförmig gekrümmt bis nahe an die Schenkel 42, 43 reichen (Fig. 5), lassen sich die Kontakte 7, 8 einfach in die Steckverbinder 5, 6 stecken. Aufgrund der gekrümmten Zungen 28 bis 30 ergibt sich eine in Steckrichtung 44 (Fig. 5) sich verjüngende Einstecköffnung 9, die ein einfaches Einführen der Kontakte 7, 8 ermöglicht. Da die Zungen 28 bis 30 bis zur Quermittelebene Q der Steckverbinder 5, 6 reichen, werden die Zungen durch die Kontakte 7, 8 elastisch verformt, so daß sie mit einem ausreichend hohen Druck an beiden Seiten der Kontakte 7, 8 anliegen. Der Abstand, den die freien Enden 36 bis 38 der Zungen 28 bis 30 von den Schenkeln 42, 43 der Steckverbinder 5, 6 haben, ist ausreichend groß, um die elastische Verformung des Zungen 28 bis 30 beim Einstecken der Kontakte 7, 8 zu ermöglichen. Die Kontakte 7, 8 lassen sich bei Bedarf einfach aus den Steckverbindern 9, 10 herausziehen. Die Platine 1 mit den Steckverbindern 5, 6 kann somit einfach und schnell auf die Kontakte 7, 8 der Leiterplatte 4 gesteckt werden.

## Patentansprüche

1. Heckleuchte für Kraftfahrzeuge, mit mindestens einer Leiterplatte (4), die mindestens einen Anschluß (15) für eine elektrische Zuleitung, Aufnahmen (4a bis 4d) für Leuchtmittel sowie mindestens einen Kontakt (7, 8) für eine Platine (1) aufweist, **dadurch gekennzeichnet, daß** die Platine (1) mit mindestens einem Steckverbinder (5, 6) versehen ist,
der wenigstens zwei federelastische Zungen (28 bis 30) aufweist, die gegensinnig gegeneinander gebogen sind und zwischen denen der Kontakt (7, 8) der Leiterplatte (4) klemmend gehalten ist, und daß die Platine (1) LEDs (2) als Leuchtmittel trägt.

2. Leuchte nach Anspruch 1,
**dadurch gekennzeichnet, daß** der Steckverbinder (5, 6) stiftartige Steckteile (11 bis 14) aufweist, die durch Öffnungen (9) der Platine (1) ragen und in dieser befestigt, vorzugsweise verlötet sind.

3. Leuchte nach Anspruch 1 oder 2,
**dadurch gekennzeichnet, daß** der Steckverbinder (5, 6) drei, vorzugsweise etwa halbkreisförmig gebogene federelastische Zungen (28 bis 30) aufweist.

4. Leuchte nach einem der Ansprüche 1 bis 3,
**dadurch gekennzeichnet, daß** der Steckverbinder (5, 6) U-förmig ausgebildet ist, und daß vorteilhaft die Zungen (28 bis 30) zwischen Schenkeln (42, 43) des Steckverbinders (5, 6) liegen und sich von einem Quersteg (34') des Steckverbinders (5, 6) aus erstrecken.

5. Leuchte nach einem der Ansprüche 1 bis 4,
**dadurch gekennzeichnet, daß** der Steckverbinder (5, 6) aus einem vorzugsweise rechteckigen Plattenteil gestanzt ist, und daß vorzugsweise der Steckverbinder (5, 6) an den Enden seiner Schenkel (42, 43) jeweils wenigstens einen, vorzugsweise zwei Steckteile (11 bis 14) aufweist.

6. Leuchte nach einem der Ansprüche 1 bis 5,
**dadurch gekennzeichnet, daß** die Zungen (28 bis 30) im wesentlichen gleich lang sind und vorzugsweise auf einander gegenüberliegenden Seiten liegen.

7. Leuchte nach einem der Ansprüche 1 bis 6,
**dadurch gekennzeichnet, daß** sich eine mittlere Zunge (30) in entgegengesetzter Richtung zu den anderen Zungen (28, 29) erstreckt, und daß vorzugsweise die mittlere Zunge (30) größere Breite hat als die anderen, seitlichen Zungen (28, 29), die vorteilhaft in Stirnansicht deckungsgleich zueinander liegen.

8. Leuchte nach einem der Ansprüche 1 bis 7,
**dadurch gekennzeichnet, daß** der Steckverbinder (5, 6) symmetrisch zu seiner Längsmittelebene (L) ausgebildet ist.

9. Leuchte nach einem der Ansprüche 1 bis 8,
**dadurch gekennzeichnet, daß** die Zungen (28 bis 30), senkrecht zur Längsmittelebene (L) des Steckverbinders (5, 6) gesehen, einander in der Quermittelebene (Q) des Steckverbinders (5, 6) berühren.

10. Leuchte nach einem der Ansprüche 1 bis 9,
**dadurch gekennzeichnet, daß** die Zungen (28 bis 30) mit ihren freien Enden (36 bis 38) etwa in Höhe der freien Enden der Schenkel (42, 43) des Steckverbinders (5, 6) liegen.

11. Leuchte nach einem der Ansprüche 1 bis 10,
**dadurch gekennzeichnet, daß** die Zungen (28 bis 30), in Richtung der Quermittelebene (Q) gesehen, eine in Steckrichtung (44) sich verjüngende Einführöffnung (9, 10) begrenzen.

12. Leuchte nach einem der Ansprüche 1 bis 11,
**dadurch gekennzeichnet, daß** die Längsmittelebene der mittlerer Zunge (30) in der Längsmittelebene (L) des Steckverbinders (5, 6) liegt.

13. Leuchte nach einem der Ansprüche 1 bis 12,
**dadurch gekennzeichnet, daß** der Kontakt (7, 8) der Leiterplatte (4) an einem aus der Leiterplattenebene herausstehenden Leiterplattenteil (16) vorgesehen ist.

## Claims

1. A rear lamp for motor vehicles, comprising at least one printed circuit board (4) having at least one terminal (15) for an electric supply line, mounts (4a to 4d) for illuminating means and at least one contact (7, 8) for a plate (1), **characterised in that** the plate (1) is provided with at least one plug connector (5, 6) having at least two resilient tongues (28 to 30) which are bent in opposite directions towards one other and between which the contact (7, 8) of the printed circuit board (4) is clamped, and **in that** the plate (1) carries LEDs (2) as illuminating means.

2. A lamp according to claim 1, **characterised in that** the plug connector (5, 6) has pin-type plug parts (11 to 14) which project through openings (9) in the plate (1) and are fixed, preferably soldered in said openings (9).

3. A lamp according to claim 1 or 2, **characterised in that** the plug connector (5, 6) has three resilient tongues (28 to 30) preferably bent approximately into a semi-circle.

4. A lamp according to any one of claims 1 to 3, **characterised in that** the plug connector (5, 6) is U-shaped and **in that** the tongues (28 to 30) are advantageously arranged between arms (42, 43) of the plug connector (5, 6) and extend from a crosspiece (34') thereof.

5. A lamp according to any one of claims 1 to 4, **characterised in that** the plug connector (5, 6) is stamped out of a preferably rectangular sheet part and **in that** the plug connector (5, 6) preferably has at least one, preferably two plug parts (11 to 14) on the ends of each of its arms (42, 43).

6. A lamp according to any one of claims 1 to 5, **characterised in that** the tongues (28 to 30) are substantially of equal length and are preferably arranged on opposite sides.

7. A lamp according to any one of claims 1 to 6, **characterised in that** a middle tongue (30) extends in the opposite direction to the other tongues (28, 29) and **in that** the middle tongue (30) is preferably wider than the other, lateral tongues (28, 29) which are advantageously congruent when seen in end view.

8. A lamp according to any one of claims 1 to 7, **characterised in that** the plug connector (5, 6) is formed symmetrically to its longitudinal central plane (L).

9. A lamp according to any one of claims 1 to 8, **characterised in that** the tongues (28 to 30) touch one another in the transverse central plane (Q) of the plug connector (5, 6) when viewed perpendicularly to the longitudinal central plane (L) of the plug connector (5, 6).

10. A lamp according to any one of claims 1 to 9, **characterised in that** the free ends (36 to 38) of the tongues (28 to 30) lie approximately at the level of the free ends of the arms (42, 43) of the plug connector (5, 6).

11. A lamp according to any one of claims 1 to 10, **characterised in that** the tongues (28 to 30) define an insertion opening (9, 10) tapering in the insertion direction (44) when viewed in the direction of the transverse central plane (Q).

12. A lamp according to any one of claims 1 to 11, **characterised in that** the longitudinal central plane of the middle tongue (30) lies in the longitudinal central plane (L) of the plug connector (5, 6).

13. A lamp according to any one of claims 1 to 12, **characterised in that** the contact (7, 8) of the printed circuit board (4) is provided on a printed circuit board part (16) projecting out of the plane of the printed circuit board (4).

## Revendications

1. Feu arrière pour véhicule automobile, comportant au moins une carte à circuits imprimés (4) qui présente au moins un branchement (15) pour une ligne d'amenée électrique, des logements (4a à 4d) pour des lampes ainsi qu'au moins un contact (7, 8) pour une platine (1), **caractérisé en ce que** la platine (1) est pourvue d'au moins un connecteur (5, 6) qui présente au moins deux languettes élastiques (28 à 30) qui sont recourbées en sens contraire et entre lesquelles le contact (7, 8) de la carte à circuits imprimés (4) est maintenu par serrage, et **en ce que** la platine (1) porte des diodes électroluminescentes (2) en tant que lampes.

2. Feu selon la revendication 1, **caractérisé en ce que** le connecteur (5, 6) présente des pièces enfichables (11 à 14) en forme de broches qui font saillie à travers des ouvertures (9) de la platine (1) et qui sont fixées, de préférence soudées dans celle-ci.

3. Feu selon l'une ou l'autre des revendications 1 et 2, **caractérisé en ce que** le connecteur (5, 6) présente trois languettes élastiques (28 à 30) de préférence recourbées approximativement en forme de demi-cercle.

4. Feu selon l'une des revendications 1 à 3, **caractérisé en ce que** le connecteur (5, 6) est réalisé en forme de U, et **en ce qu'**avantageusement, les languettes (28 à 30) se trouvent entre des branches (42, 43) du connecteur (5, 6) et s'étendent depuis une traverse (34') du connecteur (5, 6).

5. Feu selon l'une des revendications 1 à 4, **caractérisé en ce que** le connecteur (5, 6) est découpé à partir d'une partie de plaque de préférence rectangulaire, et **en ce que** de préférence, le connecteur (5, 6) présente aux extrémités de ses branches (42, 43) au moins une, de préférence deux parties enfichables (11 à 14).

6. Feu selon l'une des revendications 1 à 5, **caractérisé en ce que** les languettes (28 à 30) ont sensiblement la même longueur et sont situées de préférence sur des côtés mutuellement opposés.

7. Feu selon l'une des revendications 1 à 6, **caractérisé en ce qu'**une languette médiane (30) s'étend en direction opposée par rapport aux autres languettes (28, 29), et **en ce que** de préférence la languette médiane (30) a une largeur supérieure à celle des autres languettes (28, 29) latérales qui coïncident avantageusement l'une avec l'autre en vue frontale.

8. Feu selon l'une des revendications 1 à 7, **caractérisé en ce que** le connecteur (5, 6) est réalisé symétrique par rapport à son plan médian longitudinal (L).

9. Feu selon l'une des revendications 1 à 8, **caractérisé en ce que** vu perpendiculairement au plan médian longitudinal (L) du connecteur, les languettes (28 à 30) se touchent mutuellement dans le plan médian transversal (Q) du connecteur (5, 6).

10. Feu selon l'une des revendications 1 à 9, **caractérisé en ce que** les languettes (28 à 30) sont situées avec leurs extrémités libres (36 à 38) approximativement à la hauteur des extrémités libres des branches (42, 43) du connecteur (5, 6).

11. Feu selon l'une des revendications 1 à 10, **caractérisé en ce que** vu en direction du plan médian transversal (Q), les languettes (28 à 30) limitent une ouverture d'introduction (9, 10) se rétrécissant en direction d'enfichage (44).

12. Feu selon l'une des revendications 1 à 11, **caractérisé en ce que** le plan médian longitudinal de la languette médiane (30) est situé dans le plan médian longitudinal (L) du connecteur (5, 6).

13. Feu selon l'une des revendications 1 à 12, **caractérisé en ce que** le contact (7, 8) de la carte à circuits imprimés (4) est prévue sur une partie (16) de carte à circuits imprimés qui fait saillie hors du plan de la carte à circuits imprimés.
